# EUROPÄISCHE PATENTSCHRIFT

(11) **EP 1 521 295 B1**
(45) Veröffentlichungstag und Bekanntmachung des Hinweises auf die Patenterteilung: **02.11.2016**
(21) Anmeldenummer: 04022980.9
(22) Anmeldetag: 27.09.2004
(51) Int. Cl.: H01L 21/20, C30B 25/02, C30B 29/40, H01L 33/00

(54) **Verfahren zum Herstellen einer epitaktischen Bauelementschichtenfolge und optoelektronischer Halbleiterchip**
Method for forming an epitaxial layer sequence in a component and optoelectronic semiconductor chip
Méthode de fabrication d'une succession de couches épitaxiales d'un composant et puce optoélectronique semiconductrice

(30) Priorität: 30.09.2003 DE 10345413; 30.12.2003 DE 10361659
(43) Veröffentlichungstag der Anmeldung: 06.04.2005
(73) Patentinhaber: OSRAM Opto Semiconductors GmbH, 93055 Regensburg (DE)
(72) Erfinder: Behres, Alexander, 93309 Kelheim (DE); Linder, Norbert, 93173 Wenzenbach (DE); Mayer, Bernd, 93049 Regensburg (DE)
(74) Vertreter: Epping - Hermann - Fischer

(56) Entgegenhaltungen:
- US-A- 5 194 922
- US-A- 5 442 203
- US-A- 5 753 933
- US-B1- 6 542 528

## Beschreibung

Die Erfindung bezieht sich auf ein Verfahren zum Herstellen einer epitaktischen Bauelementschichtenfolge auf der Basis eines ersten III/V-Verbindungshalbleitermaterialsystems mit einem ersten Gruppe V-Element auf einem Substrat oder einer Pufferschicht, das bzw. die ein Material auf der Basis eines zweiten III/V-Verbindungshalbleitermaterialsystems mit einem zweiten Gruppe V-Element umfaßt, das von dem ersten Gruppe V-Element verschieden ist. Sie bezieht sich weiterhin auf einen entsprechenden optoelektronischen Halbleiterchip.

Insbesondere bei optoelektronischen Halbleiterchips auf der Basis solcher Verbindungshalbleitermaterialien, die in der Regel auf Substraten epitaktisch aufgewachsen werden, die nicht aus dem gleichen Materialsystem stammen wie das der Bauelement-Schichtenfolge, bedarf es einer Verringerung des Einflusses der Substratqualität auf die sogenannten aktiven Schichten der Bauelement-Schichtenfolge. Dies ist insbesondere für entsprechende Halbleiter-Laserdiodenchips, und hier wiederum ganz besonders für solche mit InGaAlP-basierter Laserdiodenstruktur, die häufig auf GaAs-Substrate aufgewachsen wird, von besonderer Bedeutung. Ähnliches gilt aber beispielsweise auch für andere optoelektronische Halbleiterchips auf der Basis von InGaAlP.

Unter die Gruppe von optoelektronischen, sprich strahlungsemittierenden und/oder strahlungsdetektierenden Halbleiterchips auf der Basis von InGaAlP fallen vorliegend insbesondere solche Chips, bei denen die epitaktisch hergestellte strahlungserzeugende Halbleiterschichtenfolge, die in der Regel eine Schichtenfolge aus unterschiedlichen Einzelschichten aufweist, mindestens eine Einzelschicht enthält, die ein Material aus dem III-V-Verbindungshalbleitermaterialsystem InₓAl_{y}Ga_{1-x-y}P mit 0 ≤ x ≤ 1, 0 ≤ y ≤ 1 und x+y ≤ 1 aufweist. Die Halbleiterschichtenfolge kann beispielsweise einen herkömmlichen pn-Übergang, eine Doppelheterostruktur, eine EinfachQuantentopfstruktur (SQW-Struktur) oder eine Mehrfach-Quantentopfstruktur (MQW-Strukur) aufweisen. Solche Strukturen sind dem Fachmann bekannt und werden von daher an dieser Stelle nicht näher erläutert.

Der vorliegenden Erfindung liegt die Aufgabe zugrunde, ein Verfahren der eingangs genannten Art anzugeben, mit dem der Einfluss der Substratqualität insbesondere auf die optischen und elektrischen Qualitäten der Bauelement-Schichtenfolge sowie der Alterungsstabilität verringert werden kann. Weiterhin soll ein entsprechender optoelektronischer Halbleiterchip angegeben werden.

Diese Aufgaben werden durch ein Verfahren mit den Merkmalen des Patentanspruches 1 bzw. durch einen optoelektronischen Halbleiterchip mit den Merkmalen des Patentanspruches 11 gelöst. Vorteilhafte Ausführungsformen und Weiterbildungen des Verfahrens und des Halbleiterchips sind in den Unteransprüchen 2 bis 10 bzw. 12 bis 18 angegeben.

Bei dem Verfahren wird auf das Substrat bzw. auf die Pufferschicht vor dem Aufbringen der epitaktischen Bauelement-Schichtenfolge mindestens eine Schichtabfolge mit einer ersten und einer zweiten III/V-Verbindungshalbleitermaterial-schicht aufgebracht. Die erste und die zweite III/V-Verbindungshalbleitermaterialschicht weisen dabei voneinander verschiedene Zusammensetzungen auf und enthalten sowohl das erste als auch das zweite Gruppe V-Element. Damit wird vorzugsweise ein rampenartiger Übergang von Wachstum, das mit dem zweiten Gruppe V-Element stabilisiert ist, zum Wachstum, das mit dem ersten Gruppe V-Element stabilisiert ist, erzeugt.

Mit "rampenartiger Übergang" ist in diesem Zusammenhang gemeint, dass die Konzentration des zweiten Gruppe V-Elementes innerhalb der ersten und der zweiten Schicht vom Substrat aus gesehen Richtung aktive Schichtenfolge fortlaufend abnimmt und die Konzentration des ersten Gruppe V-Elements fortlaufend zunimmt. Die Konzentratinosänderungen des ersten und des zweiten Gruppe V-Elements können hierbei stetig oder in Stufen verlaufen. Weiterhin muß die Konzentration des ersten Gruppe V-Elements nicht zwingend im selben Maße vom Substrat in Richtung aktive Schichtenfolge zunehmen, wie die Konzentration des zweiten Gruppe V-Elements in diese Richtung abnimmt.

Auf das Substrat bzw. auf die Pufferschicht wird vor dem Aufbringen der epitaktischen Bauelement-Schichtenfolge eine Mehrzahl von Schichtabfolgen mit jeweils einer ersten und einer zweiten III/V-Verbindungshalbleitermaterialschicht aufgebracht. Bei einer bevorzugten Ausführungsform nimmt der Gehalt des zweiten Gruppe V-Elements in der Mehrzahl von Schichtabfolgen in Richtung vom Substrat bzw. von der Pufferschicht zur epitaktischen Bauelement-Schichtenfolge hin im Mittel ab.

Die erste (n) III/V-Verbindungshalbleitermaterialschicht(en) weist (weisen) eine quinternäre Zusammensetzung auf (diese können bei mehreren ersten III/V-Verbindungshalbleitermaterialschichten auch unterschiedlich sein) auf. Die zweite(n) III/V-Verbindungshalbleitermaterialschicht(en) weist (weisen) eine quinternäre, quaternäre, oder ternäre Zusammensetzung auf (diese können bei mehreren ersten III/V-Verbindungshalbleitermaterialschichten auch unterschiedlich sein).

Das Verfahren eignet sich bevorzugt zur Herstellung von Halbleiterchips, bei denen das Substrat ein GaAs-Substrat oder ein auf GaAs basiertes Substrat, die Bauelement-Schichtenfolge eine auf InₓGa_{y}Al_{1-x-y}P basierende III/V-Verbindungshalbleiterschichtenfolge mit 0 ≤ x ≤ 1, 0 ≤ y ≤ 1 und x+y ≤ 1 und die erste(n) und zweite(n) III/V-Verbindungshalbleitermaterialschicht (en) InₓGa_{y}Al_{1-x-y}As_{z}P_{1-z}-Schichten mit 0 ≤ x ≤ 1, 0 ≤ y ≤ 1; x+y ≤ 1 und 0 < z < 1 sind.

Besonders bevorzugt ist dann eine Mehrzahl von Schichtabfolgen vorgesehen, wobei jede Schichtabfolge eine InₓGa_{y}Al_{1-xy}As_{z}P_{1-z}-Schicht mit 0 < x < 1, 0 < y < 1; x+y ≤ 1 und 0 < z < 1 und eine GₐAs_{z}P_{1-z}-Schicht mit 0 < z < 1 umfasst oder aus einer InₓGa_{y}Al_{1-x-y}AS_{z}P_{1-z}-Schicht mit 0 < x < 1, 0 < y < 1; x+y ≤ 1 und 0 < z < 1 und einer GaAS_{z}P_{1-z}-Schicht mit 0 < z < 1 besteht.

Das Verfahren eignet sich weiterhin bevorzugt zur Herstellung von Halbleiterchips, bei denen das Substrat ein GaAs-Substrat oder ein auf GaAs basiertes Substrat, die BauelementSchichtenfolge eine auf InₓGa_{y}Al_{1-x-y}P basierende III/V-Verbindungshalbleiterschichtenfolge mit 0 ≤ x ≤ 1, 0 ≤ y ≤ 1 und x+y ≤ 1 und die erste(n) III/V-Verbindungs-halbleitermaterialschicht (en) quinternäre InₓGa_{y}Al_{1-x-y}As_{z}P_{1-z}-Schichten mit 0 < x ≤ 1, 0 < y ≤ 1; x+y ≤ 1 und 0 < z < 1 und die zweite(n) III/V-Verbindungshalbleitermaterialschicht(en) quaternäre InₓGa_{y}Al_{1-x-y}As_{z}P_{1-z}-Schichten mit 0 ≤ x ≤ 1, 0 ≤ y ≤ 1; x+y ≤ 1 und 0 < z < 1 sind.

Die Schichtdicken der ersten und der zweiten III/V-Verbindungshalbleitermaterialschicht(en) liegen vorzugsweise zwischen einschließlich 1 nm und einschließlich 50 nm.

Weitere Vorteile, vorteilhafte Ausführungsformen und Weiterbildungen des Verfahrens und des Halbleiterchips ergeben sich aus dem im Folgenden in Verbindung mit der Figur erläuterten Ausführungsbeispiel.

Die Figur zeigt eine schematische Schnittdarstellung eines Halbleiterchips, der nach einem Verfahren gemäß der Erfindung hergestellt ist.

Die im Ausführungsbeispiel dargestellten Schichtdicken sind nicht als maßstabsgerecht anzusehen. Sie sind vielmehr zum besseren Verständnis übertrieben dick und nicht mit den tatsächlichen Dickenverhältnissen zueinander dargestellt.

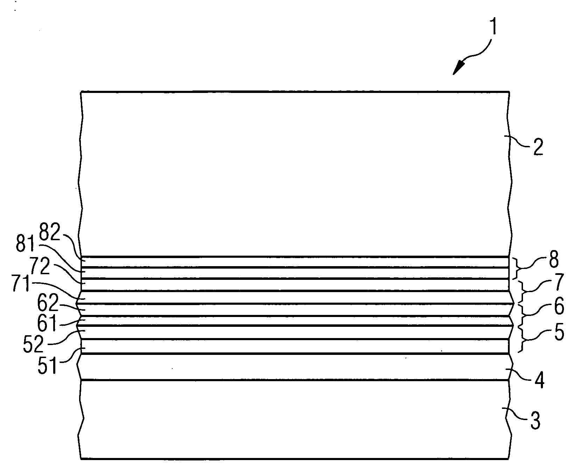

Bei dem Halbleiterchip gemäß Figur 1 handelt es sich um einen Laserdiodenchip 1 mit einer laseraktiven Bauelement-Schichtenfolge 2 auf Basis von InGaAlP, die auf einem einem GaAs-Substrat 3 epitaktisch aufgewachsen ist.

Dazu wird zunächst auf das Substrat 3 eine n-dotierte GaAs-Pufferschicht 4 epitaktisch aufgewachsen, auf der nachfolgend vier Schichtpaare (Schichtabfolgen) 5,6,7,8 mit jeweils einer n-dotierten InGaAlAsP-Schicht 51,61,71,81 (Dicke beispielsweise jeweils 20 nm) und jeweils einer n-dotierten GaAsP-Schicht 52,62,72,82 (Dicke beispielsweise jeweils 4 nm) epitaktisch aufgewachsen werden, und zwar derart, dass in der Schichtfolge die InGaAlAsP-Schichten und GaAsP-Schichten einander abwechseln. Der P-Gehalt kann dabei in den Schichtpaaren in Richtung vom Substrat zur Bauelement-Schichtenfolge hin gegenüber dem As-Gehalt zumindest im Mittel zunehmen.

Alternativ können auf die n-dotierte GaAs-Pufferschicht 4 nachfolgende auch vier Schichtpaare (Schichtabfolgen) 5,6,7,8 mit jeweils einer n-dotierten InGaAlAsP-Schicht 51,61,71,81 und jeweils einer n-dotierten GaAlAsP-Schicht 52,62,72,82 epitaktisch aufgewachsen werden.

Auf den vier Schichtpaaren 5,6,7,8 wird dann eine herkömmliche Multi-Quantentopf-Laserdiodenstruktur als Bauelement-Schichtenfolge 2 aufgewachsen.

Das epitaktische Aufwachsen erfolgt beispielsweise mittels metallorganischer Gasphasenepitaxie (MOVPE).

Bei dem Ausführungsbeispiel werden neben einem gezielten Einbau von (an der Wachstumsfront mitmigrierenden) Fremdatomen an den Heterogrenzflächen durch den In-Gehalt Versetzungsdefekte abgefangen und durch die gezielte Mischung von beiden Gruppe V-Elementen die Kristall- und Grenzflächenqualität erhöht. Durch die Beimischung von Phosphor in den Schichtpaaren 5,6,7,8 kann eine durch den In-Gehalt verursachte Absenkung der Bandkante kompensiert werden, um die elektrische Leitfähigkeit der Schichtpaare zu erhöhen und Absorption zu verhindern. Durch eine gezielte Verspannung der Schichtpaare (Übergitter) kann eine gewünschte Verspannung der gesamten Bauteilstruktur eingestellt werden. Durch die Mischung beider Gruppe V-Elemente erfolgt ein rampenartiger Übergang von hier As-stabilisiertem zu P-stabilisiertem Wachstum.

Die Erfindung ist selbstverständlich nicht auf das konkret beschriebene Ausführungsbeispiele beschränkt, sondern erstreckt sich auf sämtliche Verfahren und Halbleiterchips, die die prinzipiellen Merkmale der Erfindung aufweisen. Insbesondere ist die Erfindung grundsätzlich auf sämtliche III/V-Verbindungshalbleitermaterialsysteme anwendbar.

## Patentansprüche

1. Verfahren zum Herstellen einer epitaktischen Bauelementschichtenfolge auf der Basis eines ersten III/V-Verbindungshalbleitermaterialsystems mit einem ersten Gruppe V-Element auf einem Substrat oder einer Pufferschicht, das bzw. die ein Material auf der Basis eines zweiten III/V-Verbindungshalbleitermaterialsystems mit einem zweiten Gruppe V-Element umfaßt, das von dem ersten Gruppe V-Element verschieden ist,
wobei
- die epitaktische Bauelementschichtenfolge eine strahlungserzeugende Halbleiterschichtenfolge aufweist,
- auf das Substrat bzw. auf die Pufferschicht vor dem Aufbringen der epitaktischen Bauelementschichtenfolge eine Mehrzahl von Schichtabfolgen mit jeweils einer ersten und einer zweiten III/V-Verbindungshalbleitermaterialschicht aufgebracht wird,
- die erste und die zweite III/V-Verbindungshalbleitermaterialschicht voneinander verschiedene Zusammensetzungen aufweisen und sowohl das erste als auch das zweite Gruppe V-Element enthalten,
- die ersten III/V-Verbindungshalbleitermaterialschichten quinternäre Zusammensetzungen aufweisen, und
- die zweiten III/V-Verbindungshalbleitermaterialschichten quinternäre, quaternäre oder ternäre Zusammensetzungen aufweisen.

2. Verfahren nach Anspruch 1,
**dadurch gekennzeichnet, daß**
der Gehalt des zweiten Gruppe V-Elements in der Mehrzahl von Schichtabfolgen in Richtung vom Substrat bzw. von der Pufferschicht zur epitaktischen Bauelementschichtenfolge hin im Mittel abnimmt.

3. Verfahren nach Anspruch 1 oder 2,
**dadurch gekennzeichnet, daß**
die zweiten III/V-Verbindungshalbleitermaterialschichten quinternäre Zusammensetzungen aufweisen.

4. Verfahren nach Anspruch 1 oder 2,
**dadurch gekennzeichnet, daß**
die zweiten III/V-Verbindungshalbleitermaterialschichten quaternäre Zusammenset-zungen aufweisen.

5. Verfahren nach Anspruch 1 oder 2,
**dadurch gekennzeichnet, daß**
die zweiten III/V-Verbindungshalbleitermaterialschichten ternäre Zusammensetzungen aufweisen.

6. Verfahren nach einem der Ansprüche 1 bis 5,
**dadurch gekennzeichnet, daß**
das Substrat ein GaAs-Substrat oder ein auf GaAs basiertes Substrat ist, die Bauelementschichtenfolge eine auf InₓGa_{y}Al_{1-x-y}P basierende III/V-Verbindungshalbleiterschichtenfolge mit 0 ≤ x ≤ 1, 0 ≤ y ≤ 1 und x+y ≤ 1 ist, und die ersten und zweiten III/V-Verbindungshalbleitermaterialschichten InₓGa_{y}Al_{1-x-y}As_{z}P_{1-z}-Schichten mit 0 ≤ x ≤ 1, 0 ≤ y ≤ 1; x+y ≤ 1 und 0 < z < 1 sind.

7. Verfahren nach Anspruch 4,
**dadurch gekennzeichnet, daß**
das Substrat ein GaAs-Substrat oder ein auf GaAs basiertes Substrat ist, die Bauelementschichtenfolge eine auf InₓGa_{y}Al_{1-x-y}P basierende III/V-Verbindungshalbleiterschichtenfolge mit 0 ≤ x ≤ 1, 0 ≤ y ≤ 1 und x+y ≤ 1 ist, und die ersten III/V-Verbindungshalbleitermaterialschichten quinternäre InₓGa_{y}Al_{1-x-y}As_{z}P_{1-z}-Schichten mit 0 < x ≤ 1, 0 < y ≤ 1; x+y ≤ 1 und 0 < z < 1 und die zweiten III/V-Verbindungshalbleitermaterialschichten quaternäre InₓGa_{y}Al_{1-x-y}As_{z}P_{1-z}-Schichten mit 0 ≤ x ≤ 1, 0 ≤ y ≤ 1; x+y ≤ 1 und 0 < z < 1 sind.

8. Verfahren nach Anspruch 5,
**dadurch gekennzeichnet, daß**
jede Schichtabfolge eine InₓGa_{y}Al_{1-x-y}As_{z}P_{1-z}-Schicht mit 0 < x < 1, 0 < y < 1; x+y ≤ 1 und 0 < z < 1 und eine GaAs_{z}P_{1-z}-Schicht mit 0 < z < 1 umfasst oder aus einer InₓGa_{y}Al_{1-x-y}As_{z}P_{1-z}-Schicht mit 0 < x < 1, 0 < y < 1; x+y ≤ 1 und 0 < z < 1 und einer GaAs_{z}P_{1-z}-Schicht mit 0 < z < 1 besteht.

9. Verfahren nach Anspruch 7 oder 8,
**dadurch gekennzeichnet, daß**
durch das Aufwachsen der Schichtabfolgen ein Übergang von As-stabilisiertem Wachstum zu P-stabilisiertem Wachstum erzeugt wird, wobei in dem Übergang vom Substrat aus gesehen in Richtung der Bauelementschichtenfolge die As-Konzentration innerhalb der ersten Schicht fortlaufend abnimmt und die P-Konzentration fortlaufend zunimmt.

10. Verfahren nach einem der Ansprüche 1 bis 9,
**dadurch gekennzeichnet, daß**
Schichtdicken der ersten und der zweiten III/V-Verbindungshalbleitermaterialschichten zwischen einschließlich 1 nm und einschließlich 50 nm liegen.

11. Optoelektronischer Halbleiterchip mit einer epitaktischen Bauelementschichtenfolge auf der Basis eines ersten III/V-Verbindungshalbleitermaterialsystems mit einem ersten Gruppe V-Element auf einem Substrat oder einer Pufferschicht, das bzw. die ein Material auf der Basis eines zweiten III/V-Verbindungshalbleitermaterialsystems mit einem zweiten Gruppe V-Element umfaßt, das von dem ersten Gruppe V-Element verschieden ist,
wobei
- die epitaktische Bauelementschichtenfolge eine strahlungserzeugende Halbleiterschichtenfolge aufweist,
- zwischen dem Substrat bzw. der Pufferschicht und der epitaktischen Bauelementschichtenfolge eine Mehrzahl von Schichtabfolgen mit einer ersten und einer zweiten III/V-Verbindungshalbleitermaterialschicht angeordnet ist,
- die erste und die zweite III/V-Verbindungshalbleitermaterialschicht voneinander verschiedene Zusammensetzungen aufweisen und sowohl das erste als auch das zweite Gruppe V-Element enthalten, und
- die ersten III/V-Verbindungshalbleitermaterialschichten quinternäre Zusammensetzungen aufweisen, und
- die zweiten III/V-Verbindungshalbleitermaterialschichten quinternäre, quaternäre oder ternäre Zusammensetzungen aufweisen.

12. Optoelektronischer Halbleiterchip nach Anspruch 11,
**dadurch gekennzeichnet, daß**
der Gehalt des zweiten Gruppe V-Elements in der Mehrzahl von Schichtabfolgen in Richtung vom Substrat bzw. von der Pufferschicht zur epitaktischen Bauelementschichtenfolge hin im Mittel abnimmt.

13. Optoelektronischer Halbleiterchip nach Anspruch 11 oder 12,
**dadurch gekennzeichnet, daß**
die zweiten III/V-Verbindungshalbleitermaterialschichten quinternäre Zusammensetzungen aufweisen.

14. Optoelektronischer Halbleiterchip nach Anspruch 11 oder 12,
**dadurch gekennzeichnet, daß**
die zweiten III/V-Verbindungshalbleitermaterialschichten quaternäre Zusammensetzungen aufweisen.

15. Optoelektronischer Halbleiterchip nach Anspruch 11 oder 12,
**dadurch gekennzeichnet, daß**
die zweiten III/V-Verbindungshalbleitermaterialschichten ternäre Zusammensetzungen aufweisen.

16. Optoelektronischer Halbleiterchip nach einem der Ansprüche 11 bis 15,
**dadurch gekennzeichnet, daß**
das Substrat ein GaAs-Substrat oder ein auf GaAs basiertes Substrat ist, die Bauelementschichtenfolge eine auf InₓGa_{y}Al_{1-x-y}P basierende III/V-Verbindungshalbleiterschichtenfolge mit 0 ≤ x ≤ 1, 0 ≤ y ≤ 1 und x+y ≤ 1 ist, und die ersten und zweiten III/V-Verbindungshalbleitermaterialschichten InₓGa_{y}Al_{1-x-y}AS_{z}P_{1-z}-Schichten mit 0 ≤ x ≤ 1, 0 ≤ y ≤ 1; x+y ≤ 1 und 0 < z < 1 sind.

17. Optoelektronischer Halbleiterchip nach Anspruch 16,
**dadurch gekennzeichnet, daß**
jede Schichtabfolge eine InₓGayAl_{1-x-y}As_{z}P_{1-z}-Schicht mit 0 < x < 1, 0 < y < 1; x+y ≤ 1 und 0 < z < 1 und eine GaAs_{z}P_{1-z}-Schicht mit 0 < z < 1 umfasst oder aus einer InₓGa_{y}Al_{1-x-y}AS_{z}P_{1-z}-Schicht mit 0 < x < 1, 0 < y < 1; x+y ≤ 1 und 0 < z < 1 und einer GaAs_{z}P_{1-z}-Schicht mit 0 < z < 1 besteht.

18. Optoelektronischer Halbleiterchip nach einem der Ansprüche 11 bis 17,
**dadurch gekennzeichnet, daß**
die Schichtdicken der ersten und der zweiten III/V-Verbindungshalbleitermaterialschichten zwischen einschließlich 1 nm und einschließlich 50 nm liegen.

## Claims

1. Method for fabricating an epitaxial component layer sequence based on a first III/V compound semiconductor material system with a first group V element on a substrate or a buffer layer, which comprises a material based on a second III/V compound semiconductor material system with a second group V element, which is different from the first group V element,
wherein
- the epitaxial component layer sequence has a radiation-generating semiconductor layer sequence,
- a plurality of layer sequences with in each case a first and a second III/V compound semiconductor material layer are applied to the substrate or to the buffer layer before the application of the epitaxial component layer sequence,
- the first and second III/V compound semiconductor material layers have different compositions from one another and contain both the first and the second group V elements,
- the first III/V compound semiconductor material layers have quinternary compositions, and
- the second III/V compound semiconductor material layers have quinternary, quaternary or ternary compositions.

2. Method according to Claim 1,
**characterized in that**
the content of the second group V element in the plurality of layer sequences decreases on average in the direction from the substrate or from the buffer layer toward the epitaxial component layer sequence.

3. Method according to Claim 1 or 2,
**characterized in that**
the second III/V compound semiconductor material layers have quinternary compositions.

4. Method according to Claim 1 or 2,
**characterized in that**
the second III/V compound semiconductor material layers have quaternary compositions.

5. Method according to Claim 1 or 2,
**characterized in that**
the second III/V compound semiconductor material layers have ternary compositions.

6. Method according to one of Claims 1 to 5,
**characterized in that**
the substrate is a GaAs substrate or a GaAs-based substrate, the component layer sequence is an InₓGa_{y}Al_{1-x-y}P-based III/V compound semiconductor layer sequence where 0 ≤ x ≤ 1, 0 ≤ y ≤ 1 and x+y ≤ 1 and the first and second III/V compound semiconductor material layers are InₓGa_{y}Al_{1-x-y}As_{z}P_{1-z} layers where 0 ≤ x ≤ 1, 0 ≤ y ≤ 1; x+y ≤ 1 and 0 < z < 1.

7. Method according to Claim 4,
**characterized in that**
the substrate is a GaAs substrate or a GaAs-based substrate, the component layer sequence is an InₓGa_{y}Al_{1-x-y}P-based III/V compound semiconductor layer sequence where 0 ≤ x ≤ 1, 0 ≤ y ≤ 1 and x+y ≤ 1 and the first III/V compound semiconductor material layers are quinternary InₓGa_{y}Al_{1-x-y}AS_{z}P_{1-z} layers where 0 < x ≤ 1, 0 < y ≤ 1; x+y ≤ 1 and 0 < z < 1 and the second III/V compound semiconductor material layers are quaternary InₓGayAl_{1-x-y}As_{z}P_{1-z} layers where 0 ≤ x ≤ 1, 0 ≤ y ≤ 1; x+y ≤ 1 and 0 < z < 1.

8. Method according to Claim 5,
**characterized in that**
each layer sequence comprises an InₓGayAl_{1-x-y}AS_{z}P_{1-z} layer where 0 < x < 1, 0 < y < 1 ; x + y ≤ 1 and 0 < z < 1 and a GaAs_{z}P_{1-z} layer where 0 < z < 1, or consists of an InₓGa_{y}Al_{1-x-y}AS_{z}P_{1-z} layer where 0 < x < 1, 0 < y < 1 ; x + y ≤ 1 and 0 < z < 1 and a GaAs_{z}P_{1-z} layer where 0 < z < 1.

9. Method according to Claim 7 or 8,
**characterized in that**
the growth of the layer sequences produces a transition from As-stabilized growth to P-stabilized growth, wherein in the transition as viewed from the substrate in the direction of the component layer sequence the As concentration within the first layer continuously decreases and the P concentration continuously increases.

10. Method according to one of Claims 1 to 9,
**characterized in that**
layer thicknesses of the first and second III/V compound semiconductor material layers lie between 1 nm and 50 nm inclusive.

11. Optoelectronic semiconductor chip with an epitaxial component layer sequence based on a first III/V compound semiconductor material system with a first group V element on a substrate or a buffer layer, which comprises a material based on a second III/V compound semiconductor material system with a second group V element, which is different from the first group V element,
wherein
- the epitaxial component layer sequence has a radiation-generating semiconductor layer sequence,
- a plurality of layer sequences with a first and a second III/V compound semiconductor material layer is arranged between the substrate or the buffer layer and the epitaxial component layer sequence,
- the first and second III/V compound semiconductor material layers have different compositions from one another and contain both the first and the second group V elements, and
- the first III/V compound semiconductor material layers have quinternary compositions, and
- the second III/V compound semiconductor material layers have quinternary, quaternary or ternary compositions.

12. Optoelectronic semiconductor chip according to Claim 11,
**characterized in that**
the content of the second group V element in the plurality of layer sequences decreases on average in the direction from the substrate or from the buffer layer toward the epitaxial component layer sequence.

13. Optoelectronic semiconductor chip according to Claim 11 or 12,
**characterized in that**
the second III/V compound semiconductor material layers have quinternary compositions.

14. Optoelectronic semiconductor chip according to Claim 11 or 12,
**characterized in that**
the second III/V compound semiconductor material layers have quaternary compositions.

15. Optoelectronic semiconductor chip according to Claim 11 or 12,
**characterized in that**
- the second III/V compound semiconductor material layers have ternary compositions.

16. Optoelectronic semiconductor chip according to one of Claims 11 to 15,
**characterized in that**
the substrate is a GaAs substrate or a GaAs-based substrate, the component layer sequence is an InₓGa_{y}Al_{1-x-y}P-based III/V compound semiconductor layer sequence where 0 ≤ x ≤ 1, 0 ≤ y ≤ 1 and x+y ≤ 1 and the first and second III/V compound semiconductor material layers are InₓGa_{y}Al_{1-x-y}As_{z}P_{1-z} layers where 0 ≤ x ≤ 1, 0 ≤ y ≤ 1; x+y ≤ 1 and 0 < z < 1.

17. Optoelectronic semiconductor chip according to Claim 16,
**characterized in that**
each layer sequence comprises an InₓGa_{y}Al_{1-x-y}As_{z}P_{1-z} layer where 0 < x < 1, 0 < y < 1; x+y ≤ 1 and 0 < z < 1 and a GaAs_{z}P_{1-z} layer where 0 < z < 1, or consists of an InₓGa_{y}Al_{1-x-y}As_{z}P_{1-z} layer where 0 < x < 1, 0 < y < 1; x+y ≤ 1 and 0 < z < 1 and a GaAs_{z}P_{1-z} layer where 0 < z < 1.

18. Optoelectronic semiconductor chip according to one of Claims 11 to 17,
**characterized in that**
the layer thicknesses of the first and second III/V compound semiconductor material layers lie between 1 nm and 50 nm inclusive.

## Revendications

1. Procédé de fabrication d'une suite de couches de composant épitaxiale à base d'un premier système de matériau semiconducteur de liaison III/V avec un premier élément de groupe V sur un substrat ou une couche tampon, lequel ou laquelle comprend un matériau à base d'un deuxième système de matériau semiconducteur de liaison III/V avec un deuxième élément de groupe V qui est différent du premier élément de groupe V,
- la suite de couches de composant épitaxiale possédant une suite de couches en semiconducteur génératrice de rayonnement,
- une pluralité de séquences de couches ayant respectivement une première et une deuxième couche de matériau semiconducteur de liaison III/V étant appliquée sur le substrat ou sur la couche tampon avant l'application de la suite de couches de composant épitaxiale,
- la première et la deuxième couche de matériau semiconducteur de liaison III/V possédant des compositions respectivement différentes et contenant à la fois le premier et le deuxième élément de groupe V,
- les premières couches de matériau semiconducteur de liaison III/V possédant des compositions quinternaires, et
- les deuxièmes couches de matériau semiconducteur de liaison III/V possédant des compositions quinternaires, quaternaires ou ternaires.

2. Procédé selon la revendication 1, **caractérisé en ce que** la teneur en l'élément de groupe V dans la pluralité de séquences de couches diminue en moyenne dans la direction du substrat ou de la couche tampon vers la suite de couches de composant épitaxiale.

3. Procédé selon la revendication 1 ou 2, **caractérisé en ce que** les deuxièmes couches de matériau semiconducteur de liaison III/V possèdent des compositions quinternaires.

4. Procédé selon la revendication 1 ou 2, **caractérisé en ce que** les deuxièmes couches de matériau semiconducteur de liaison III/V possèdent des compositions quaternaires.

5. Procédé selon la revendication 1 ou 2, **caractérisé en ce que** les deuxièmes couches de matériau semiconducteur de liaison III/V possèdent des compositions ternaires.

6. Procédé selon l'une des revendications 1 à 5, **caractérisé en ce que** le substrat est un substrat au GaAs ou un substrat à base de GaAs, la suite de couches de composant est une suite de couches de matériau semiconducteur de liaison III/V à base d'InₓGa_{y}Al_{1-x-y}P, avec 0 ≤ x ≤ 1, 0 ≤ y ≤ 1 et x+y ≤ 1, et les premières et deuxièmes couches de matériau semiconducteur de liaison III/V sont des couches d'InₓGa_{y}Al_{1-x-y}As_{z}P_{1-z}, avec 0 ≤ x ≤ 1, 0 ≤ y ≤ 1 ; x+y ≤ 1 et 0 < z < 1.

7. Procédé selon la revendication 4, **caractérisé en ce que** le substrat est un substrat au GaAs ou un substrat à base de GaAs, la suite de couches de composant est une suite de couches de matériau semiconducteur de liaison III/V à base d'InₓGa_{y}Al_{1-x-y}P, avec 0 ≤ x ≤ 1, 0 ≤ y ≤ 1 et x+y ≤ 1, et les premières couches de matériau semiconducteur de liaison III/V sont des couches d'InₓGa_{y}Al_{1-x-y}As_{z}P_{1-z} quinternaires avec 0 < x ≤ 1, 0 < y ≤ 1 ; x+y ≤ 1 et 0 < z < 1 et les deuxièmes couches de matériau semiconducteur de liaison III/V sont des couches d'InₓGa_{y}Al_{1-x-y}As_{z}P_{1-z} quaternaires avec 0 ≤ x ≤ 1, 0 ≤ y ≤ 1 ; x+y ≤ 1 et 0 < z < 1.

8. Procédé selon la revendication 5, **caractérisé en ce que** chaque séquence de couches comprend une couche d'InₓGa_{y}Al_{1-x-y}As_{z}P_{1-z} avec 0 < x < 1, 0 < y < 1 ; x+y ≤ 1 et 0 < z < 1 et une couche de GaAs_{z}P_{1-z} avec 0 < z < 1, ou se compose d'une couche d'InₓGa_{y}Al_{1-x-y}As_{z}P_{1-z} avec 0 < x < 1, 0 < y < 1 ; x+y ≤ 1 et 0 < z < 1 et d'une couche de GaAs_{z}P_{1-z} avec 0 < z < 1.

9. Procédé selon la revendication 7 ou 8, **caractérisé en ce qu'**une transition d'une croissance de stabilisation de l'As vers une croissance de stabilisation du P est générée par la croissance de la séquence de couches, la concentration d'As à l'intérieur de la première couche diminuant continuellement et la concentration de P augmentant continuellement dans la transition, dans la direction de la suite de couches de composant vue depuis le substrat.

10. Procédé selon l'une des revendications 1 à 9, **caractérisé en ce que** les épaisseurs de couche des premières et deuxièmes couches de matériau semiconducteur de liaison III/V sont comprises entre 1 nm inclus et 50 nm inclus.

11. Puce en semiconducteur optoélectronique comprenant une suite de couches de composant épitaxiale à base d'un premier système de matériau semiconducteur de liaison III/V avec un premier élément de groupe V sur un substrat ou une couche tampon, lequel ou laquelle comprend un matériau à base d'un deuxième système de matériau semiconducteur de liaison III/V avec un deuxième élément de groupe V qui est différent du premier élément de groupe V,
- la suite de couches de composant épitaxiale possédant une suite de couches en semiconducteur génératrice de rayonnement,
- une pluralité de séquences de couches ayant une première et une deuxième couche de matériau semiconducteur de liaison III/V étant disposée entre le substrat ou la couche tampon et la suite de couches de composant épitaxiale,
- la première et la deuxième couche de matériau semiconducteur de liaison III/V possédant des compositions respectivement différentes et contenant à la fois le premier et le deuxième élément de groupe V, et
- les premières couches de matériau semiconducteur de liaison III/V possédant des compositions quinternaires, et
- les deuxièmes couches de matériau semiconducteur de liaison III/V possédant des compositions quinternaires, quaternaires ou ternaires.

12. Puce en semiconducteur optoélectronique selon la revendication 11, **caractérisée en ce que** la teneur en l'élément de groupe V dans la pluralité de séquences de couches diminue en moyenne dans la direction du substrat ou de la couche tampon vers la suite de couches de composant épitaxiale.

13. Puce en semiconducteur optoélectronique selon la revendication 11 ou 12, **caractérisée en ce que** les deuxièmes couches de matériau semiconducteur de liaison III/V possèdent des compositions quinternaires.

14. Puce en semiconducteur optoélectronique selon la revendication 11 ou 12, **caractérisée en ce que** les deuxièmes couches de matériau semiconducteur de liaison III/V possèdent des compositions quaternaires.

15. Puce en semiconducteur optoélectronique selon la revendication 11 ou 12, **caractérisée en ce que** les deuxièmes couches de matériau semiconducteur de liaison III/V possèdent des compositions ternaires.

16. Puce en semiconducteur optoélectronique selon l'une des revendications 11 à 15, **caractérisée en ce que** le substrat est un substrat au GaAs ou un substrat à base de GaAs, la suite de couches de composant est une suite de couches de matériau semiconducteur de liaison III/V à base d'InₓGa_{y}Al_{1-x-y}P, avec 0 ≤ x ≤ 1, 0 ≤ y ≤ 1 et x+y ≤ 1, et les premières et deuxièmes couches de matériau semiconducteur de liaison III/V sont des couches d'InₓGa_{y}Al_{1-x-y}As_{z}P_{1-z}, avec 0 ≤ x ≤ 1, 0 ≤ y ≤ 1 ; x+y ≤ 1 et 0 < z < 1.

17. Puce en semiconducteur optoélectronique selon la revendication 16, **caractérisée en ce que** chaque séquence de couches comprend une couche d'InₓGa_{y}Al₁₋ₓ₋yAs_{z}P_{1-z} avec 0 < x < 1, 0 < y < 1 ; x+y ≤ 1 et 0 < z < 1 et une couche de GaAs_{z}P_{1-z} avec 0 < z < 1, ou se compose d'une couche d'InₓGa_{y}Al_{1-x-y}As_{z}P_{1-z} avec 0 < x < 1, 0 < y < 1 ; x+y ≤ 1 et 0 < z < 1 et d'une couche de GaAs_{z}P_{1-z} avec 0 < z < 1.

18. Puce en semiconducteur optoélectronique selon l'une des revendications 11 à 17, **caractérisée en ce que** les épaisseurs de couche des premières et deuxièmes couches de matériau semiconducteur de liaison III/V sont comprises entre 1 nm inclus et 50 nm inclus.
